# EUROPEAN PATENT APPLICATION

(11) **EP 2 645 612 A2**
(43) Date of publication of application: **02.10.2013**
(21) Application number: 13001262.8
(22) Date of filing: 13.03.2013
(51) Int. Cl.: H04L 1/00

(54) **Memory Architecture for Turbo Decoder**

(30) Priority: 30.03.2012 US 201261618049 P; 25.09.2012 US 201213626317
(71) Applicant: Broadcom Corporation, Irvine, CA 92617 (US)
(72) Inventor: Hahm, Mark, Hartland, WI 53029 (US); Liu, Bin, San Diego, CA 92127 (US)
(74) Representative: Jehle, Volker Armin

(57) **Abstract**

Disclosed are various embodiments that provide turbo decoding implemented as at least a portion of baseband processing circuitry. An input bit stream may be divided into a set of code blocks and a first code block may be separated from the set of code blocks. A hybrid automatic repeat request (HARQ) process is performed on the first code block to generate a processed first code block. The processed first code block is stored in an incremental redundancy (IR) buffer. A turbo decoding process is performed on the processed first code block to generate decoded first code block data and the decoded first code block data is stored in an external memory. The processed first code block is removed from the IR buffer for decoding a remaining portion of the set of code blocks.

## Description

### CROSS-REFERENCE TO RELATED APPLICATIONS

This application is a utility application that claims priority to co-pending U.S. Provisional Patent Application titled, "Cellular Baseband Processing", having Serial Number 61/618,049, filed March 30, 2012, which is entirely incorporated herein by reference.

### BACKGROUND

Cellular wireless communication allows for many wireless mobile devices to communicate over a cellular network through base stations. For a wireless mobile device communicating in a cellular network, various channel conditions may affect the quality of the wireless signal received at the wireless mobile device. Wireless signals may be encoded and redundantly transmitted to a wireless mobile device to address varying channel conditions. Accordingly, wireless mobile devices may be equipped to decode wireless signals transmitted over the cellular network.

### BRIEF SUMMARY OF THE INVENTION

According to an aspect, a method comprises:
dividing an input bit stream into a set of code blocks and separating a first code block from the set of code blocks;
performing a hybrid automatic repeat request (HARQ) process on the first code block to generate a processed first code block;
storing the processed first code block in an incremental redundancy (IR) buffer;
performing a turbo decoding process on the processed first code block to generate decoded first code block data and storing the decoded first code block data in an external memory; and
removing the processed first code block from the IR buffer for decoding a remaining portion of the set of code blocks.

Advantageously, the method further comprises:
separating a second code block from the set of code blocks;
performing the HARQ process on the second code block to generate a processed second code block;
wherein removing the processed first code block from the IR buffer for decoding a remaining portion of the set of code blocks comprises storing the processed second code block in the IR buffer.

Advantageously, the method further comprises:
individually performing the HARQ process on each code block of the set of code blocks to generate corresponding processed code blocks;
individually performing the turbo decoding process on each of the processed code blocks to generate corresponding decoded code block data;
aggregating each of the decoded code block data to generate a decoded bit stream; and
performing an error detection process on the decoded bit stream to generate an error detection value.

Advantageously, the method further comprises removing the decoded code block data associated with each code block from the external memory and the IR buffer in response to the error detection value matching a predetermined expected value.

Advantageously, the method further comprises:
receiving a transmitted bit stream in response to the error detection value not matching a predetermined expected value; and
dividing the retransmitted bit stream into retransmitted code blocks, wherein the retransmitted code blocks comprise a first retransmitted code block, the first retransmitted code block corresponding to the first code block.

Advantageously, the method further comprises storing the first retransmitted code block in the IR buffer and loading the first code block into the IR buffer from the external memory.

Advantageously, the method further comprises performing a chase combining process on the first retransmitted code block and the first code block by performing a read operation from the IR buffer.

Advantageously, performing the turbo decoding process comprises executing a set of decoders to decode the first code block in parallel.

According to an aspect, a system comprises:
baseband processing circuitry configured to divide an input bit stream into a set of code blocks;
an incremental redundancy (IR) buffer configured to individually store each code block;
a turbo decoder module configured to individually decode each code block to generate corresponding decoded code block data, each code block being sequentially read from the IR buffer, the turbo decoder module comprising a set of parallel turbo decoders configured for parallel processing; and
memory configured to store the decoded code block data associated with at least a portion of the set of code blocks.

Advantageously, the set of code blocks comprises a first code block, wherein the turbo decoder module is configured to segment the first code block into code block segments, wherein the turbo decoder module is configured to allocate each code block segment to a corresponding parallel turbo decoder, wherein each code block segment is divided into a predetermined number of sequential evaluation windows for processing each code block segment in parallel.

Advantageously, each parallel turbo decoder is configured to perform a forward probabilities alpha operation and a backward probabilities beta operation for each evaluation window to generate the decoded code block data.

Advantageously, the forward probabilities alpha operation and the backward probabilities beta operation are performed simultaneously for each evaluation window.

Advantageously, each parallel turbo decoder is configured to calculate respective log likelihood ratio data for each evaluation window by employing the forward probabilities alpha operation and the backward probabilities beta operation, wherein the calculation of the respective log likelihood ratio data for each evaluation window is initialized at a predetermined intermediate point in the evaluation window.

Advantageously, the set of parallel turbo decoders is arranged as a first subset of parallel turbo decoders and a second subset of parallel turbo decoders, wherein the first subset of parallel turbo decoders is configured to start decoding the corresponding set of code block segments according to a first start time, wherein the second subset of parallel turbo decoders is configured to start decoding the corresponding set of code block segments according to a second start time, wherein the second start time is staggered from the first start time.

According to an aspect, a system comprises:
processing circuitry configured to:
   divide an input bit stream of a transmission time interval into a set of code blocks, each code block having a fixed length;
   sequentially store each code block in an incremental redundancy (IR) buffer; and
   individually decode, by a turbo decoder module, each code block to generate corresponding decode data for the respective code block, the turbo decoder module comprising a set of parallel turbo decoders configured for parallel processing.

Advantageously, the processing circuitry is further configured to:
sequentially remove each code block from the IR buffer after the code block has been individually decoded; and
store at least a portion of the decode data in external memory in response to individually decoding each code block.

Advantageously, the processing circuitry is further configured to divide each code block into a set of evaluation windows, wherein the processing circuitry is configured to simultaneously employ a forward probabilities alpha operation and a backward probabilities beta operation for each window.

Advantageously, the processing circuitry is further configured to initialize a calculation of a respective log likelihood ratio data for each evaluation window according to a halfway point in the evaluation window.

Advantageously, the set of parallel turbo decoders is configured to stagger a respective start time of each of the parallel turbo decoders for processing portions of each code block.

Advantageously, each respective start time is staggered according to half a length of an evaluation window of the set of evaluation windows.

### BRIEF DESCRIPTION OF THE DRAWINGS

Many aspects of the present disclosure can be better understood with reference to the following drawings. The components in the drawings are not necessarily to scale, emphasis instead being placed upon clearly illustrating the principles of the disclosure. Moreover, in the drawings, like reference numerals designate corresponding parts throughout the several views.

FIG. 1 is a drawing of a receiver system according to various embodiments of the present disclosure.

FIG. 2A is a drawing of an example of baseband processing circuitry implemented within the receiver system of FIG. 1 according to various embodiments of the present disclosure.

FIG. 2B is a drawing of an example of baseband processing circuitry implemented within the receiver system of FIG. 1 according to various embodiments of the present disclosure.

FIG. 3 is a drawing of an example of baseband processing circuitry implemented within the receiver system of FIG. 1 according to various embodiments of the present disclosure.

FIG. 4 is a drawing of an example of baseband processing circuitry implemented within the receiver system of FIG. 1 according to various embodiments of the present disclosure.

FIG. 5A is a drawing of an example of a turbo decoder module implemented within the receiver system of FIG. 1 according to various embodiments of the present disclosure.

FIG. 5B is a drawing of an example of a turbo decoder module implemented within the receiver system of FIG. 1 according to various embodiments of the present disclosure.

FIG. 6A is a flowchart illustrating one example of functionality implemented as portions of baseband processing circuitry of the receiver system of FIG. 1 according to various embodiments of the present disclosure.

FIG. 6B is a flowchart illustrating one example of functionality implemented as portions of baseband processing circuitry of the receiver system of FIG. 1 according to various embodiments of the present disclosure.

### DETAILED DESCRIPTION

The present disclosure relates to managing memory usage when performing turbo decoding operations on bit streams. A wireless device receives a wireless signal and converts the received signal into a digital bit stream. To decode large bit streams, many processing resources may be required. This may be the case when multiple wireless signals are received by devices configured for multiple-in-multiple-out (MIMO) communication.

Various embodiments of the present disclosure are directed to employing a turbo decoding module that may access local incremental redundancy (IR) buffer data and external memory data. For example, an input data stream may be divided into code blocks. These code blocks may be processed by a turbo decoding module individually and in series. The turbo decoding module may read a single code block from an IR buffer, decode the code block, and write the decoded code block data to external memory. Then, the IR buffer may be cleared and a subsequent code block may be loaded in to the IR buffer.

Various embodiments are also directed to employing parallel turbo decoders to process a single code block in parallel. For example, a code block may be divided into segments and each segment may be processed in parallel by a corresponding parallel turbo decoder. Furthermore, each segment may be divided into a plurality of sequential evaluation windows to execute forward probabilities alpha operations and a backward probabilities beta operation for each evaluation window.

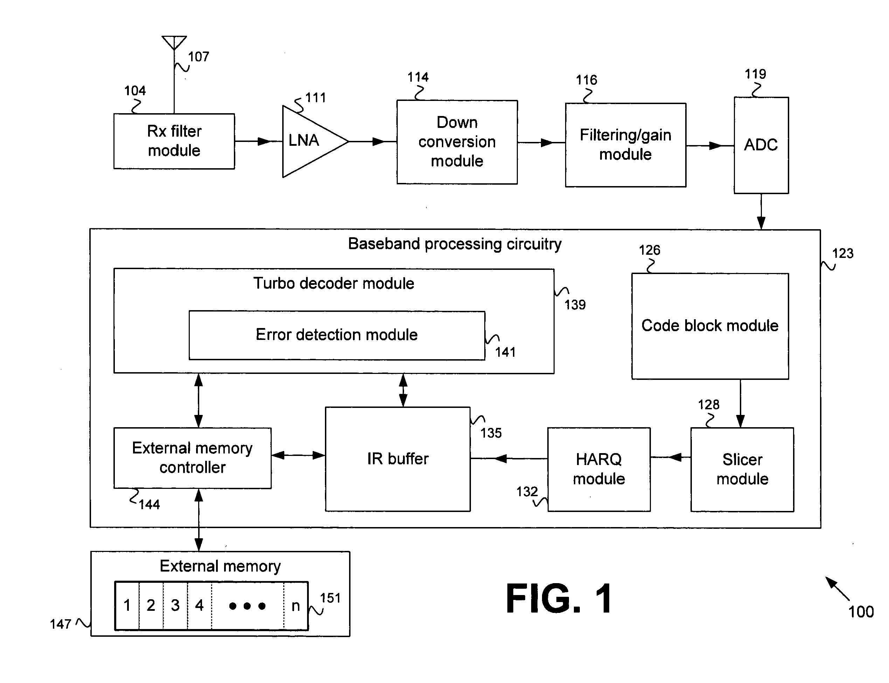

With reference to FIG. 1, shown is a receiver system 100 according to various embodiments. The receiver system 100 may be implemented as at least a portion of a wireless communication system of a wireless device. The wireless device may be, for example, a laptop computer, notepad, notebook, ultrabook, tablet, cellular device, or any other device configured to receive wireless signals over a network. The receiver system 100 may be configured to receive wireless signals transmitted over a network. Wireless signals, for example, may express digitally formatted information that has been mixed and modulated by carrier signals to facilitate wireless communication. To this end, the receiver system 100 is configured to convert received wireless signals into a digital format. The receiver system 100 comprises a receiver filter module 104, an antenna 107, a low noise amplifier (LNA) 111, a down conversion module 114, a filtering/gain module 116, an analog-to-digital converter (ADC) 119, baseband processing circuitry 123, external memory 147 or any other component that facilitates wireless reception.

The antenna 107 may receive inbound wireless signals transmitted from a remote device such as, for example, a base station. The receiver filter module 104 is communicatively coupled to the antenna such that the receiver filter module 104 filters out frequencies to facilitates wireless communication. The LNA 111 receives the filtered wireless signal and amplifies this signal to produce an amplified inbound wireless signal. The LNA 111 provides the amplified inbound wireless signal to the down conversion module 114 which produces a low intermediate frequency (IF) signal or baseband signal. For example, the down conversion module 114 may use a local oscillator to down convert the amplified inbound wireless signal. The filtering/gain module 116 may adjust the gain and/or filter the IF or baseband signal. The ADC 119 may format the IF or baseband signal to the digital domain. The ADC 119 produces a digital signal that contains the information expressed by the inbound wireless signal.

The baseband processing circuitry 123 demodulates, demaps, descrambles, and/or decodes the digital signal to recapture the information expressed in the inbound wireless signal in accordance with a wireless communication standard or standards used in the receiver system 100. In various embodiments, the baseband processing circuitry 123 is implemented as at least a portion of a microprocessor. The baseband processing circuitry 123 may be implemented using one or more circuits, one or more microprocessors, application specific integrated circuits, dedicated hardware, digital signal processors, microcomputers, central processing units, field programmable gate arrays, programmable logic devices, state machines, or any combination thereof. In yet other embodiments, the baseband processing circuitry 123 may include one or more software modules executable within one or more processing circuits. The baseband processing circuitry 123 may further include memory configured to store instructions and/or code that causes the baseband processing circuitry 123 to execute data communication functions.

The baseband processing circuitry 123 may comprise a code block module 126, a slicer module, 128, a hybrid automatic repeat request (HARQ) module 132, an incremental redundancy (IR) buffer 135, a turbo decoder module 139, an external memory controller 144, and any other component or module for facilitating the functionality of the baseband processing circuitry 123.

The baseband processing circuitry 123 may prepare an input bit stream for the code block module 126. The input bit stream reflects an instance of a transmission time interval (TTI). The TTI may determine a data size of the input bit stream specified by a wireless communication standard. As a non-limiting example, the input bit stream expresses despreaded symbols subject to decoding. In various embodiments, the code block module 126 divides the input bit stream into a set of fixed length code blocks. The code blocks, for example, may be arranged in sequence to reconstruct the input bit stream.

The slicer module 128 extracts symbols and provides an output to the HARQ module 132. In various embodiments, the slicer module 128 operates on a code block basis. That is to say, the slicer module 128 slices code blocks received from the code block module 126 one at a time in a serial manner such that each code block is processed individually. The HARQ module 132 may be configured to perform bit collection, de-rate matching, chase combination and/or any other HARQ function. The HARQ module 132 receives the sliced code blocks from the slicer module 128 and generates corresponding de-rate matched code blocks. The HARQ module 132 operates on code blocks one at a time in a serial manner such that each code block is processed individually.

After the HARQ module 132 processes a particular code block by generating a de-rate matched code block, the HARQ module 132 stores the processed code block in the IR buffer 135. The IR buffer 135 may be minimized in size in order to hold a single code block at a given point in time. As at least one benefit of the present disclosure, this may lead to an optimized process architecture with a reduced on-chip memory size. It may be the case that pre-existing data stored in the IR buffer 135, such as an old code block, may need to be removed before writing a new code block to the IR buffer 135.

The baseband processing circuitry 123 further comprises a turbo decoder module 139. The turbo decoder module 139 is configured to read individually processed code blocks stored in the IR buffer 135 and perform one or more turbo decoding operations on the code block to generate corresponding decoded code block data. The turbo decoder module 139 decodes processed code blocks stored in the IR buffer 135 one at a time in a serial manner such that each code block is processed individually. In various embodiments, the turbo decoder module 139 is configured to perform a Bahl, Cocke, Jelinek, Raviv (BCJR) algorithm for decoding processed code blocks stored in the IR buffer 135. The turbo decoder module 139 may perform forward probabilities (alpha) operations and backward probabilities (beta) operations on each processed code block. The alpha operations and beta operations are combined to generate a log likelihood ratio (LLR) calculation for facilitating error detection.

The turbo decoder module 139 may comprise an error detection module 141. In various embodiments, the error detection module is configured to perform a cyclic redundancy check (CRC) on decoded code block data such as, for example, LLR data. For example, once each code block is individually decoded, a CRC operation may be performed to determine whether a retransmission of the data is required or whether new, subsequent data is to be transmitted to the receiver system 100. For example, if the CRC is passed, new data represented in a subsequent TTI is processed. However, if the CRC is failed, then data represented by the current TTI may be retransmitted and analyzed by the baseband processing circuitry 123. In various embodiments, the receiver system 100 continues to request retransmissions until a maximum number of CRC failures occur.

The baseband processing circuitry 123 may comprise an external memory controller 144. The baseband processing circuitry 123 may be communicatively coupled to external memory 147. The external memory controller 144 allows data to be transferred from the baseband processing circuitry 123 to external memory 147. For example, decoded code block data associated with corresponding code blocks may be stored in external memory 147. The external memory controller 144 may also facilitate data to be read from external memory 147 to the baseband processing circuitry 123. For example, code blocks 151 that have been processed by the HARQ module 132 may be loaded from external memory 147 and written into the IR buffer 135.

### Individual Code Block Processing

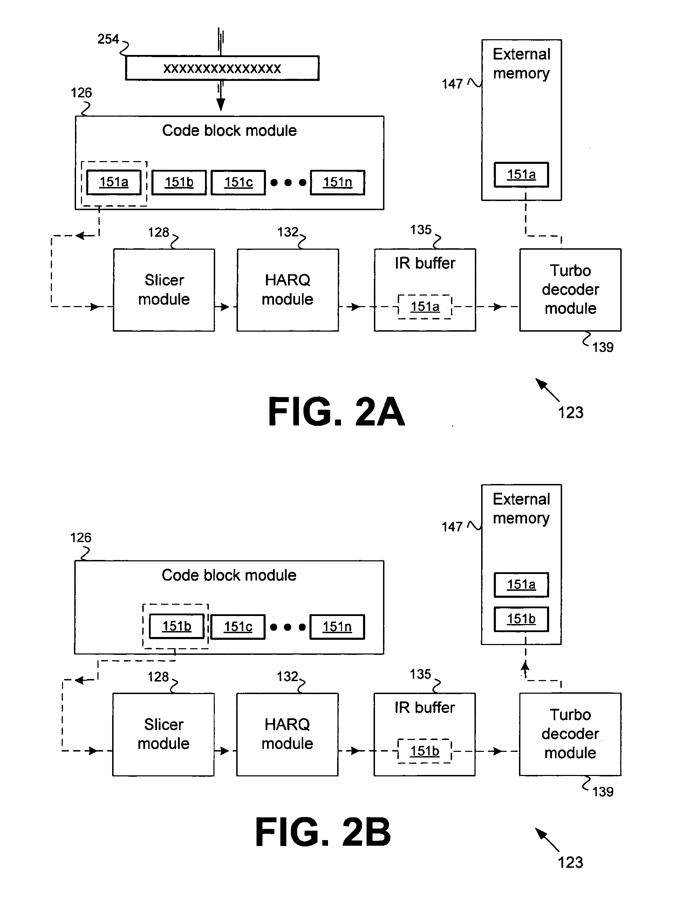

Turning now to FIG. 2A, shown is a drawing of an example of baseband processing circuitry 123 implemented within the receiver system 100 of FIG. 1 according to various embodiments of the present disclosure. FIG. 2A provides a non-limiting example of performing turbo decoding on individual code blocks of an input bit stream 254.

The baseband processing circuitry 123 prepares an input bit stream 254 and sends the input bit stream 254 to the code block module 126. In various embodiments, the input bit stream represents data expressed during a TTI. The code block module 126 divides the input bit stream 254 into a set of code blocks 151a-n. Each code block 151a-n may be a fixed length in terms of a number of bits. The code block module 126 may be configured to send a first code block 151a to the slicer module 128. The slicer module 128 may operate on the first code block 151a to generate a processed first code block 151a. For example, the first code block 151a may be processed such that it is subjected to slicing. By slicing the first code block 151a, various symbols expressed in the first code block 151a may be extracted.

After the first code block 151a is processed/sliced, by the slicer module 128, the processed first code block 151a is sent to the HARQ module 132 for further processing. The HARQ module 132 may process the first code block 151a by performing bit collection, de-rate matching, block interleaving, bit priority mapping, or any other HARQ function. For example, the HARQ module 132 may generate a rate matching parameter for the first code block 151. The HARQ module 132 may receive the extracted symbols associated with the first code block 151a and generate soft symbols for the first code block 151a. The output of the HARQ module 132, which is the processed first code block 151a, is stored in the IR buffer 135.

In various embodiments, the IR buffer 135 is configured to individually store a code block 151a-n that has been processed. In the non-limiting example of FIG. 2A, the first code block 151a is processed by at least the slicer module 128 and/or the HARQ module 132 and then stored in the IR buffer 135. Moreover, remaining code blocks 151b-151n are not stored in the IR buffer 135 while the first code block 151a is stored in the IR buffer 135.

The turbo decoder module 139 may be configured to read data from the IR buffer 135 and perform a decoding process. For example, the turbo decoder module 139 reads a single code block at a time, such as, for example, the first code block 151a. The turbo decoder module 139 performs one or more decoding operations on any code block 151a-n stored in the IR buffer 135. In the non-limiting example of FIG. 2A, the turbo decoder module 139 processes the first code block 151a by decoding the first code block 151a and then optionally stores in external memory 147 the decoded code block data 151a of the first code block 151a that has been decoded. The turbo decoder module 139 may use an external memory controller 144 (FIG. 1) to facilitate writing the decoded first code block data 151a to external memory 147.

When performing the decoding operation on the first code block 151a, the turbo decoder module 139 may perform one or more alpha operations and one or more beta operations on the first code block 151a to generate log likelihood ratio data. The decoded first code block data 151a that is stored in external memory 147 may comprise any decoding data such as the log likelihood ratio data.

As seen in the non-limiting example of FIG. 2A, a single code block 151a-n, such as the first code block 151, is processed individually by each module on a per-code block basis. In various embodiments, the processed first code block 151a is removed from the IR buffer 135 after the processed first code block 151 is used by the turbo decoder module 139. The processed first code block 151a may also be removed from the IR buffer 135 in response to the processed first code block being stored in the external memory 147.

Moving to FIG. 2B, shown is a drawing of an example of baseband processing circuitry 123 implemented within the receiver system 100 of FIG. 1 according to various embodiments of the present disclosure. FIG. 2B provides a non-limiting example of performing turbo decoding on individual code blocks of an input bit stream 254 (FIG. 2A). Moreover, FIG. 2B depicts a non-limiting example of processing a second code block 151b after a first code block 151a is initialized for processing.

A second code block 151b may be separated from the input bit stream 254 in the code block module 126. After the slicer module 128 processes the first code block 151a, the slicer module 128 may begin processing the second code block 151b. The processed second code block 151b is then passed from the slicer module 128 to the HARQ module 132. The HARQ module 132 may begin operating on the processed second code block 151b after the HARQ module 132 has completed processing the first code block 151a. The HARQ module 132 may write the second code block 151b output to the IR buffer 135. In various embodiments, the IR buffer 135 space is cleared of any previously stored code blocks before the HARQ module 132 writes to the IR buffer 135.

The turbo decoder module 139 reads the second code block 151b that has been processed by the HARQ module 132 and processes the second code block 151b. The processed second code block 151b is stored in external memory 147. To this end, the external memory 147 stores decoded data each processed code block 151a-n in a sequential order. This allows the baseband processing circuitry 123 to read/load decode data associated with each code block 151a-n separately for subsequent processing.

The baseband processing circuitry 123 may continue processing a third code block 151c and all subsequent code blocks until all code blocks 151a-n have been processed and decoded. The last code block 151 n is processed by the slicer module 128 and the HARQ module 132 and then stored in the IR buffer 135. The last code block 151 n may then be decoded by the turbo decoder module 139 to generate decode data associated with the last code block 151 n. In various embodiments, the decode data associated with the last code block 151 n that is decoded is not stored in external memory 147. Instead, the decode data of the last code block 151n remains in the IR buffer 135.

When each code block 151a-n is decoded by the turbo decoder module 139, the baseband processing circuitry 123 may aggregate all the decoded code block data 151a-n and perform an error detection process. To aggregate the decoded code block data 151a-n, baseband processing circuitry 123 may read the decoded code block data 151a-n from a combination of the external memory 147 and the IR buffer 135. For example, the decoded last code block data 151 n may be stored in the IR buffer 135 while all other decode data of code blocks 151a-n-1 is stored in external memory 147. The result of aggregating the decoded code block data 151a-n is effectively equivalent to decoding the input bit stream 254 (FIG. 2A) as a whole.

After aggregating all the decoded code block data 151a-n, the turbo decoder module 139 may perform an error detection process using an error detection module 141 (FIG. 1). The error detection process may be, for example, a cyclic redundancy check (CRC) that generates a corresponding CRC value for the aggregated decoded code block data. The error detection module 141 compares the generated CRC value against a predetermined expected CRC value. If the generated CRC value matches the predetermined expected CRC value, then the input bit stream 254 is deemed to pass CRC such that the input bit stream is designated as a sufficient reception.

However, if the generated CRC value does not match the predetermined expected CRC value, then the input bit stream 254 is deemed to have failed. A CRC that is failed may indicate to the receiver system 100 (FIG. 1) that the input bit stream 254 is noisy or otherwise low in signal quality/clarity. When a CRC is failed, a retransmitted signal may be sent to the receiver system 100. In various embodiments the baseband processing circuitry 123 initiates a request for the retransmitted signal.

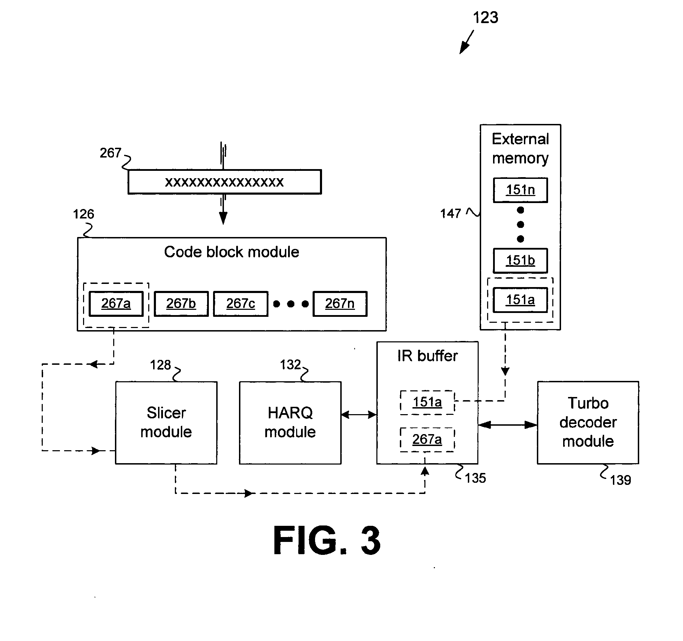

Next, in FIG. 3, shown is a drawing of an example of the baseband processing circuitry 123 implemented within the receiver system 100 of FIG. 1 according to various embodiments of the present disclosure. FIG. 3 provides a non-limiting example of performing turbo decoding when a retransmitted signal is required. The retransmitted signal may be sent to the receiver system 100 in responses to the decoded input bit stream failing a CRC.

When a decoded input bit stream fails a CRC, a wireless retransmitted signal is sent to the receiver system 100. The receiver system 100 converts the retransmitted signal into a retransmitted bit stream 267 such that the retransmitted bit stream 267 is in the digital domain. The retransmitted bit stream 267 may express the same substantive information as the input bit stream 254 (FIG. 2A). However, due to transmission channel characteristics, the received bit information may vary from the retransmitted bit stream 267 and the input bit stream 254. Further, in various embodiments, the retransmitted bit stream 267 may be subjected to an encoding procedure that varies the formatting from the input bit stream 254. For example, the retransmitted bit stream 267, prior to transmission, may have been subjected to different puncturing patterns, different coding rates, different data transmission rates, etc., or any other encoding process that changes the formatting of the retransmitted bit stream 267 from the input bit stream 254.

As seen in FIG. 3, the baseband processing circuitry 123 receives the retransmitted bit stream 267 in response to a failed CRC of the input bit stream 254. When the baseband processing circuitry 123 receives the retransmitted bit stream 267, all the decoded code block data 151a-n (FIG. 2A) of the input bit stream 254 may be stored in external memory 147. To this end, the IR buffer 135 has available memory capacity for facilitating the processing and decoding of the retransmitted bit stream 267.

The code block module 126 is configured to divide the retransmitted bit stream 267 into a set of retransmitted code blocks 267a-n. Each retransmitted code block 267a-n corresponds to a code block 151a-n of the input bit stream 254. For example, the first retransmitted code block 267a corresponds to the first code block 151a; the second retransmitted code block 267b corresponds to the second code block 151b, etc. To this end, the first retransmitted code block 267a expresses the same information as the first code block 151a. However, the bit pattern of the first retransmitted code block 267a may vary from first code block 151a due to channel reception conditions, or any other encoding processing.

In various embodiments, the first transmitted code block 267a is sent to the slicer module 128 for slicing. Thereafter, the first transmitted code block 267a is stored in the IR buffer 135. The decoded first code block data 151a that is stored in external memory 147 is then loaded into the IR buffer 135. This may be achieved through the use of an external memory controller 144 (FIG. 1).

The HARQ module 132 may access the IR buffer 135 to perform HARQ operations on a combination of the first transmitted code block 267a and the decoded first code block data 151a. For example, the HARQ module 132 may perform a chase combining process on the first transmitted code block 267a and the decoded first code block data 151a. The HARQ module may effectively use maximum-ratio combining to combine the bits of the first transmitted code block 267a with the bits associated with the decoded first block data 151a. This allows the baseband processing circuitry 123 to fill in missing or uncertain bits contained in the original input bit stream 254.

The baseband processing circuitry 123 may continue processing the remaining transmitted code blocks 267b-n in the manner discussed above by combining each retransmitted code block 267a-n with a corresponding code block 151a-n. Additionally, the error detection module 141 (FIG. 1) of a turbo decoder module 139 may perform an error detection check on the combination of the retransmitted bit stream 267 and the input bit stream 254. If the error detection fails, then a subsequent retransmitted signal may be sent to the receiver system 100 for additional combining. For each time a retransmitted signal is combined with a previous transmitted signal, the likelihood of passing the error detection may increase.

### Parallel Processing Code Blocks using alpha/beta Computations

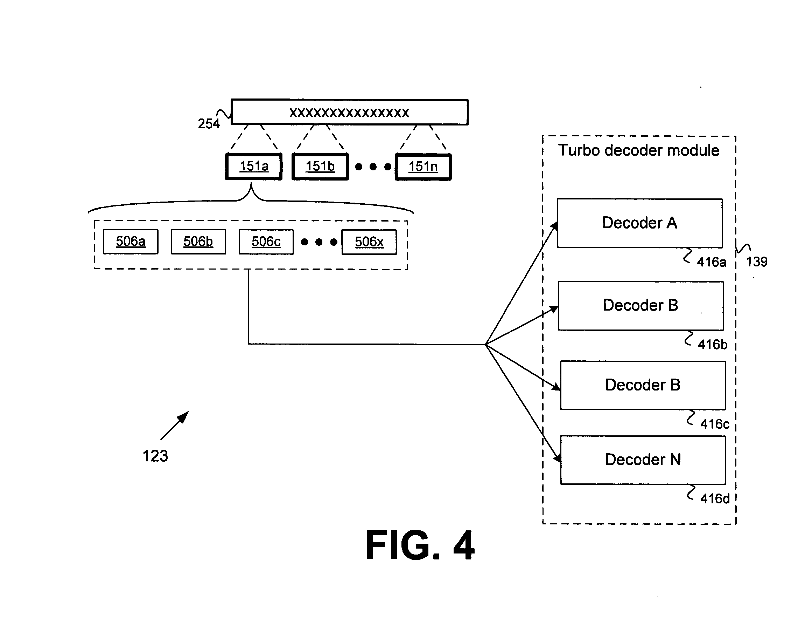

Turning now to FIG. 4, shown is an example of the baseband processing circuitry 123 implemented within the receiver system 100 of FIG. 1 according to various embodiments of the present disclosure. FIG. 4 provides a non-limiting example of performing parallel decoding on a single code block 151a-n.

As seen in FIG. 4, an input bit stream 254 is divided into a set of fixed length code blocks 151a-n. A single code block 151a-n may be processed and stored in the IR buffer 135 (FIG. 1) on an individual basis. A code block 151a-d that is stored in the IR buffer 135 is accessed by a turbo decoder module 139. The turbo decoder module 139 comprises a set of turbo decoders 416a-d to decode a code block 151a-n in parallel. The baseband processing circuitry 123 may divide a given code block 151a-n into a plurality of evaluation windows 506a-x. Each evaluation window 506a-x corresponds to a non-overlapping range of time that is unique with respect to one another.

In various embodiments, each turbo decoder 416a-d may be allocated a respective segment of sequential evaluation windows 506a-x. To this end, each turbo decoder 416a-d processes a respective segment of sequential evaluation windows in parallel. Each segment comprises a pre-determined number of evaluation windows 506a-x.

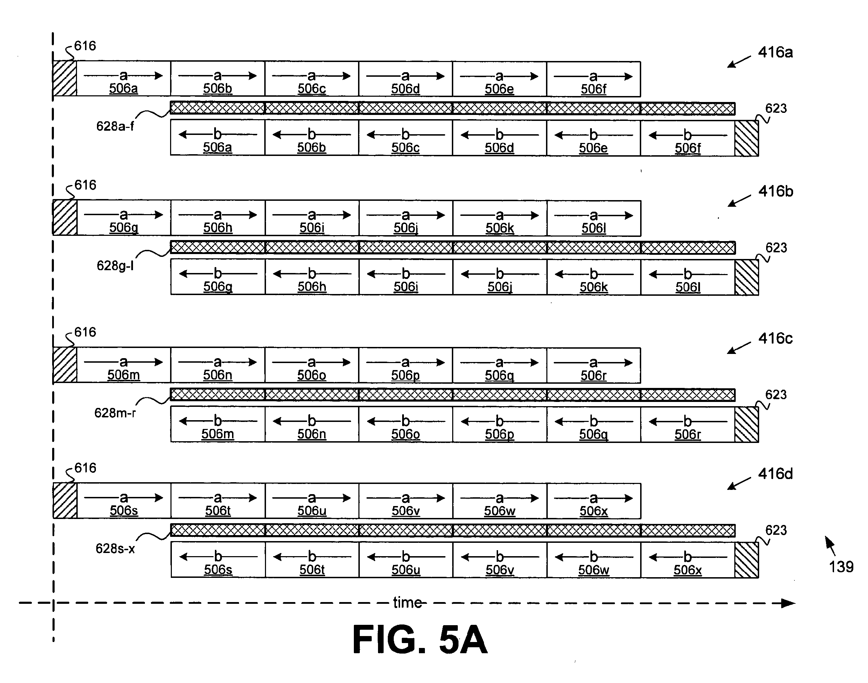

Moving to FIG. 5A, shown is a drawing of an example of a turbo decoder module 139 implemented within the receiver system 100 of FIG. 1 according to various embodiments of the present disclosure. FIG. 5A depicts a non-limiting example of performing alpha and beta operations on a code block 151a-n (FIG. 2A).

FIG. 5A depicts four turbo decoders 416a-d configured to perform alpha and beta operations on code blocks 151a-n. Each turbo decoder 416a-d receives a respective segment of sequential evaluation windows 506a-x. For example, a first turbo decoder 416a receives a first segment of evaluation windows 506a-f. A second turbo decoder 416b receives a second segment of evaluation windows 506g-I. A third turbo decoder 416c receives a third segment of evaluation windows 506m-r. And a fourth turbo decoder 416d receives a fourth segment of evaluation windows 506s-x.

As seen in FIG. 5A, each turbo decoder 416a-d processes a respective segment in parallel along a time axis. To initialize the processing of each segment, a pre-fetch 616 may occur. The pre-fetch 616 is performed to load the code block data into each turbo decoder. The pre-fetch 616 operation consumes an amount of time before each turbo decoder 416a-d decodes a respective segment. Similarly, when a turbo decoder 416a-d completes processing a segment, a post-put 623 is performed for writing any decoding data to a memory/buffer.

When a turbo decoder 416a-d begins decoding a respective segment, the turbo decoder 416a-d begins by performing an alpha operation on the first evaluation window 506a, 506g, 506m, 506s of the respective segment. The alpha operation is a forward probabilities operation that processes the data of a corresponding evaluation window 506a-x from beginning to end.

When the turbo decoder 416a-d completes performing an alpha operation on the first evaluation window 506a, 506g, 506m, 506s of the respective segment, the turbo decoder 416a-d continues performing alpha operations on the second evaluation window 506b, 506h, 506n, 506t of the respective segment. However, each turbo decoder 416a-d simultaneously performs a beta operation on the first evaluation window 506a, 506g, 506m, 506s of the respective segment while performing the alpha operation on the second evaluation window 506b, 506h, 506n, 506t of the respective segment. The beta operation is a backward probabilities operation that processes the data of a corresponding evaluation window 506a-x from end to beginning.

Thus, in the example of FIG. 5A, the alpha operation and the beta operation are not performed simultaneously for the same evaluation window 506a-x. For example, with regard to the first evaluation window 506a of the first segment, the alpha operation is first performed and the beta operation is performed after the alpha operation is complete.

By performing an alpha operation and a beta operation on an evaluation window 506a-x, a corresponding log likelihood ratio (LLR) 628a-x may be calculated. For example, for the first evaluation window 506a of the first segment, a corresponding LLR calculation 628a is calculated. This LLR calculation 628a is initialized when the alpha operation is complete and the beta operation begins. When calculating this LLR calculation 628a, the turbo decoder 416a uses the results of the alpha operation of the first evaluation window 506a and combines these results with the results of the beta operation of the first evaluation window 506a while the turbo decoder 416a performs the beta operations on the first evaluation window. Under this implementation of FIG. 5A, the LLR calculation 628a data for the first evaluation window 506a is calculated after the alpha operations are complete.

Furthermore, as seen in the non-limiting example of FIG. 5A, each turbo decoder 416a-d begins processing the respective segment at the same time. In addition, the alpha and beta operations are performed sequentially on a particular evaluation window 506a-x.

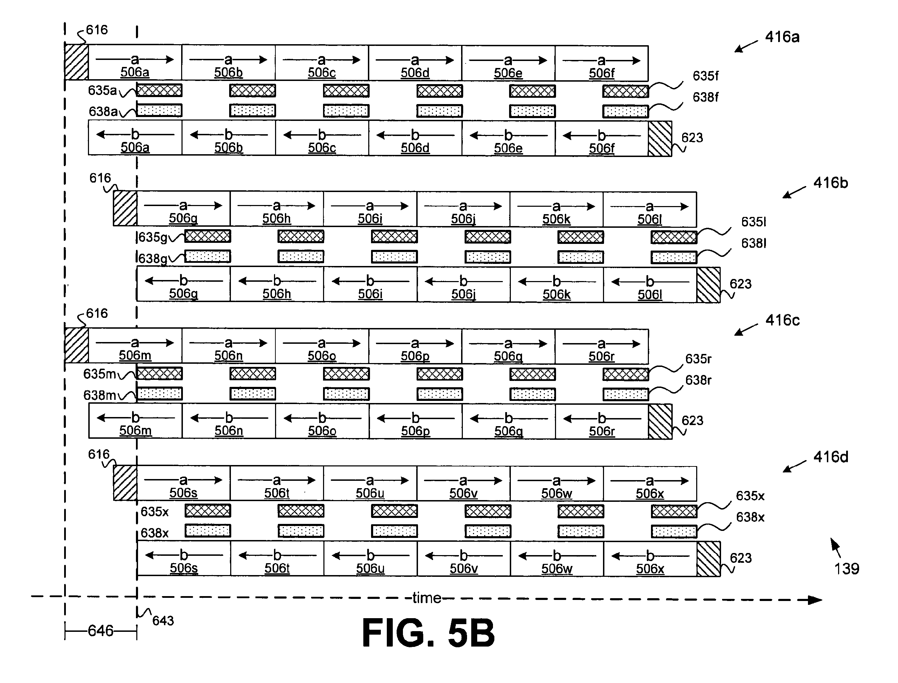

Moving onto FIG. 5B, shown is an example of a turbo decoder module 139 implemented within the receiver system 100 of FIG. 1 according to various embodiments of the present disclosure. FIG. 5B provides a decoding scheme that is an alternative to the decoding scheme of FIG. 5A.

FIG. 5B provides a non-limiting example of performing the alpha and beta operations for a particular evaluation window 506a-x simultaneously rather than sequentially. Furthermore, FIG. 5B provides a non-limiting example where the start times for each turbo decoder 416a-d is staggered rather than maintaining the same start time for each turbo decoder 416a-d.

Each turbo decoder 416a-d in the turbo decoder module 139 is configured to receive a respective segment of a code block 151a-n (FIG. 2A). Each segment is divided into a predetermined number of sequential evaluation windows 506a-x. In various embodiments, an alpha operation and a beta operation are simultaneously performed on each evaluation window 506a-x such that the alpha operation and beta operation for a particular evaluation window 506a-x is executed concurrently rather than sequentially. When simultaneously performing the alpha operation and the beta operation on a particular evaluation widow 506a-x, corresponding LLR calculations 635a-x, 638a-x are initialized at an intermediate point of the evaluation window 506a-x. The intermediate point 643, for example, may be a halfway point between the beginning of the evaluation window and the ending of the evaluation window.

A first LLR calculation 635a-x reflects the result of performing an alpha operation and a beta operation on the latter half of the evaluation windows 506a-x. A second LLR calculation 638a-x reflects the result of performing an alpha operation and a beta operation on the former half of the evaluation windows 506a-x.

For example, assume that the first turbo decoder 416a is processing the first evaluation window 506a of the first segment. As the first turbo decoder 416a processes this particular evaluation window 506a, the first turbo decoder 416a simultaneously performs an alpha operation and a beta operation on the particular evaluation window 506a. As the first turbo decoder 416a advances through the particular evaluation window 506a, the first decoder reaches an intermediate point 643. At the intermediate point, the turbo decoder initializes the calculation of the first LLR calculation 635a and the second LLR calculation 638a. The first LLR calculation 635a is based on the first half of the beta operation of the evaluation window 506a, which corresponds to the second half of the data expressed by the evaluation window 506a. The first LLR calculation 635a is also based on the second half of the alpha operation of the evaluation window 506a, which corresponds to the second half of the data expressed by the evaluation window 506a.

Furthermore, in the example above, the second LLR calculation 638a is based on the second half of the beta operation of the evaluation window 506a, which corresponds to the first half of the data expressed by the evaluation window 506a. The second LLR calculation 638a is also based on the first half of the alpha operation of the evaluation window 506a, which corresponds to the first half of the data expressed by the evaluation window 506a.

By combining the first LLR calculation 635a and the second LLR calculation 638a for a particular evaluation window 506a, the total LLR for the evaluation window 506a may be determined. The total LLR, in this case, is equivalent to the corresponding LLR calculation 628a of FIG. 5A. Thus, FIG. 5B provides an alternative scheme for calculating the LLR calculation 628a for the first evaluation window 506a.

Furthermore, FIG. 5B provides a non-limiting example of turbo decoders 416a-d that are executed in parallel to processes respective segments of a code block 151a-n (FIG. 2A). In various embodiments, the start time for a portion of the turbo decoders 416a, c may be staggered or otherwise offset from the start time of another portion of the turbo decoders 416b, d. For example, the offset amount 646, which is the difference in the start times, may be equivalent to half the time it takes to process an evaluation window 506a-x. By offsetting the start time of a portion of the turbo decoders 416a, c from the start time of another portion of turbo decoders 416b, d the turbo decoder module 139 may realize a decrease in processing time equivalent to half the length of the duration of an evaluation window. In this respect, this decrease in processing time may be achieved without increasing hardware resources directed to executing alpha operations and beta operations.

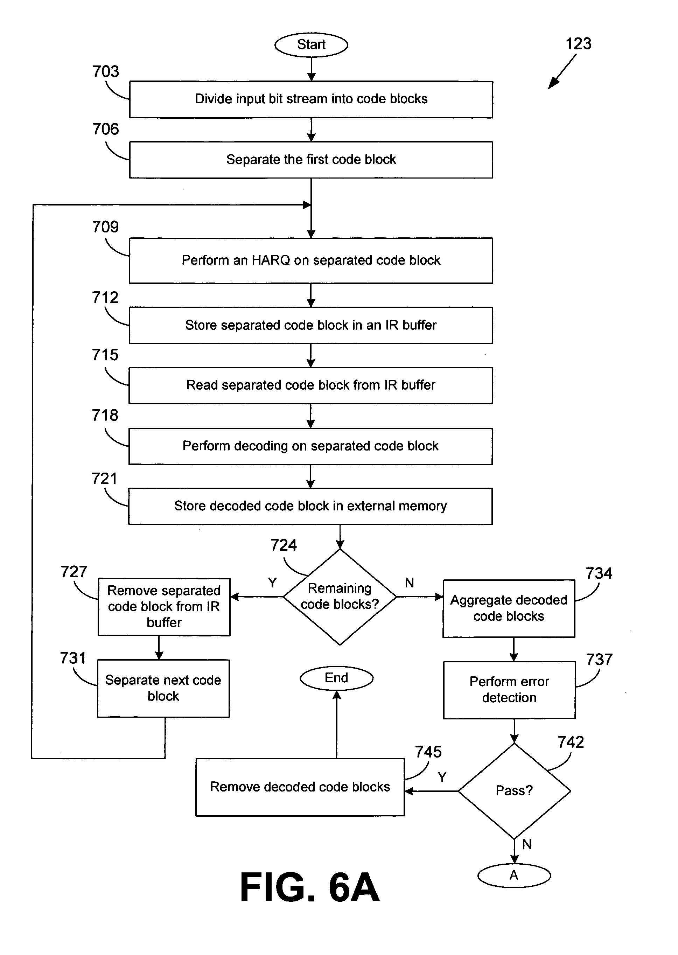

Turning now to FIG. 6A, shown is a flowchart illustrating one example of functionality implemented as portions of the baseband processing circuitry 123 in a receiver system 100 of FIG. 1 according to various embodiments of the present disclosure. It is understood that the flowchart of FIG. 6A provides merely an example of the many different types of functional arrangements that may be employed to implement the operation of the portion of the logic executed by the baseband processing circuitry 123 as described herein. As an alternative, the flowchart of FIG. 6A may be viewed as depicting an example of steps of a method implemented in the baseband processing circuitry 123 according to one or more embodiments.

Beginning with reference number 703, the baseband processing circuitry 123 divides an input bit stream 254 (FIG. 2A) into code blocks 151a-n (FIG. 2A). In various embodiments, the input bit stream represents data expressed in the digital domain that spans a TTI. This data may be received wirelessly by at least a portion of a receiver system 100 (FIG. 1). In various embodiments, a code block module 126 (FIG. 1), implemented as a portion of the baseband processing circuitry 123, divides the input bit stream 254 into fixed length code blocks 151a-n. At reference number 706, the baseband processing circuitry 123 separates a first code block 151a from the set of code blocks 151a-n. The first code block 151a is separated for individually processing the first code block 151a.

At reference number 709, the baseband processing circuitry 123 performs an HARQ process on the separated code block 151a-n. The baseband processing circuitry 123 may employ an HARQ module 132 (FIG. 1). The HARQ module may determine soft symbols of the separated code block 151a-n. In various embodiments, a slicer module 128 slices the separated code block 151a-n before the separated code block 151a-n is processed by the HARQ module 132. The HARQ module 132 stores the processed, separated code block 151a-n in an IR buffer 135 (FIG. 1), as seen at reference number 712. In various embodiments, the IR buffer is optimized in size for handling a single processed code block 151a-n at a time.

At reference number 715, the baseband processing circuitry 123 reads the separated code block from the IR buffer 135. For example, a turbo decoder module 139 (FIG. 1) implemented by the baseband processing circuitry 123 performs the read operation. In various embodiments, the turbo decoder module 139 comprises a set of parallel turbo decoders for processing a single code block 151a-n in parallel. The turbo decoder module 139 is configured to read/write decoding data such as, for example, LLR data, to external memory 147 to facilitate a decoding of each code block 151a-n.

At reference number 718, the baseband processing circuitry 123 performs one or more decoding operations on the separated code block 151a-n. At reference number 721, the baseband processing circuitry 123 stores the coded code block 151a-n in external memory 147 (FIG. 1). The baseband processing circuitry 123 may use an external memory controller 144 (FIG. 1) to facilitate writing to the external memory 147. The external memory 147 may be, for example, off chip memory that is separate from the IR buffer 135. The external memory 147 may also be a memory cache used by the baseband processing circuitry 123.

At reference number 724, if there are additional code blocks 151b-n that are remaining to be decoded, then, as seen at reference number 727, the baseband processing circuitry 123 removes the separated code block 151a-n from the IR buffer. To this end, the baseband processing circuitry 123 clears at least a portion of the data in the IR buffer 135 to increase the available space to store a subsequent processed code block 151b-n. At reference number 731, the baseband processing circuitry 123 separates the next code block 151a-n from the set of code blocks 151a-n. The baseband processing circuitry 123 individually processes the next code block 151a-n.

After all remaining code blocks 151b-n have been processed and decoded, the baseband processing circuitry 123 branches to reference number 734. At reference number 734, the baseband processing circuitry 123 aggregates all the data of the individually decoded code blocks 151a-n. The aggregated decoded code block data 151a-n is equivalent to decoding the input bit stream 254 as a whole. To aggregate the decoded code block data 151a-n, the baseband processing circuitry 123 may read decoded code block data 151a-n from a combination of external memory 147 and the IR buffer 135 or from a dedicated decoded-bits buffer. The baseband processing circuitry 123 performs an error detection process on the aggregated decoded code block data 151a-n, as seen at reference number 737. For example, an error detection module 141 (FIG. 1) may perform a CRC operation. The error detection operations performed in the baseband processing circuitry 123 may be configured for a variety of implementations such as, for example, performing partial error detection operations on each individual code block 151a-n. In this non-limiting example, partial error detection results are generated and combined with one another at the end of the decoding process. A pass/fail status for the input bit stream 254 may be determined according to the combined partial error detection results.

At reference number 742, the CRC may be passed or failed. If the CRC is passed, then, at reference number 745, the decoded code block data 151a-n is removed from memory. For example, the IR buffer 135 and the external memory 147 may be cleared of the code block data. The baseband processing circuitry 123 is then ready to decode the next input bit stream.

If the CRC is fails, then the baseband processing circuitry 123 branches to reference A.

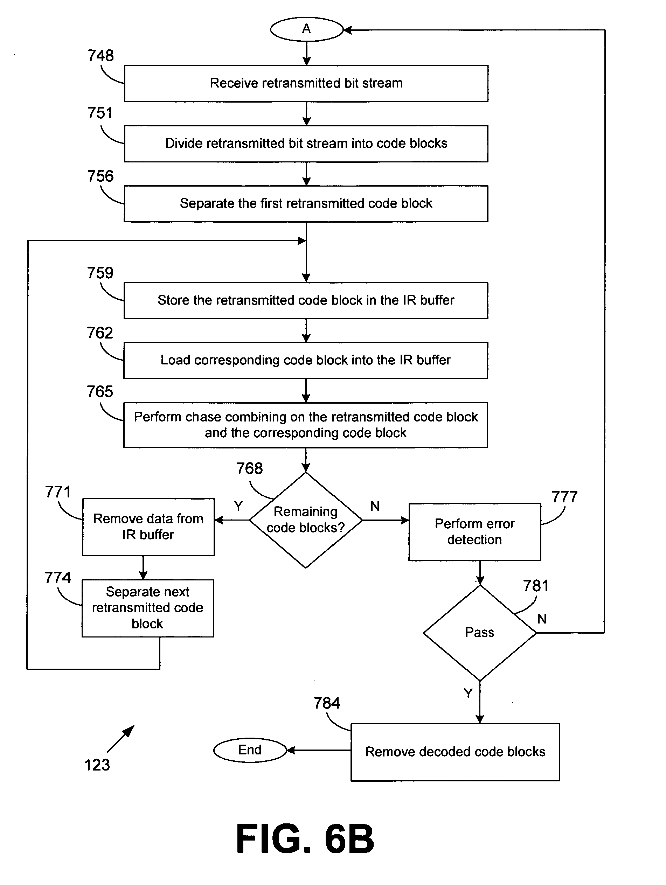

Turning now to FIG. 6B, shown is a flowchart illustrating one example of functionality implemented as portions of the baseband processing circuitry 123 in a receiver system 100 of FIG. 1 according to various embodiments of the present disclosure. It is understood that the flowchart of FIG. 6B provides merely an example of the many different types of functional arrangements that may be employed to implement the operation of the portion of the logic executed by the baseband processing circuitry 123 as described herein. As an alternative, the flowchart of FIG. 6B may be viewed as depicting an example of steps of a method implemented in the baseband processing circuitry 123 according to one or more embodiments. The flowchart of FIG. 6B begins at reference A.

At reference number 748, the baseband processing circuitry 123 receives a retransmitted bit stream 267 (FIG. 3). The retransmitted bit stream 267 may be received in response to the input bit stream 254 (FIG. 2A) failing the CRC. At reference number 751, the baseband processing circuitry 123 divides the retransmitted bit stream 267 into retransmitted code blocks 267a-n (FIG. 3). Each retransmitted code block 267a-n corresponds to a respective code block 151a-n (FIG. 2A). The baseband processing circuitry 123 may employ the code block module 126 (FIG. 1) to divide the retransmitted bit stream 267 into the retransmitted code blocks 267a-n.

At reference number 756, the baseband processing circuitry 123 separates the first retransmitted code block 267a. The first retransmitted code block 267a corresponds to the first code block 151a. The first retransmitted code block 267a may be separated from the remaining retransmitted code blocks 267b-n to facilitate individual processing/decoding of each retransmitted code block 267a-n.

At reference number 759, the baseband processing circuitry 123 stores the retransmitted code block in the IR buffer 135 (FIG. 1). At reference number 762, the baseband processing circuitry 123 loads the corresponding code block 151a-n into the IR buffer 135. For example, if the first retransmitted code block 267a is prepared for processing and is accordingly stored in the IR buffer 135, then the first code block 151a of the input bit stream 254 (FIG. 2A) is loaded in the IR buffer 135. The first code block 151a may be loaded from external memory 147 (FIG. 1) as a result of previous decoding of the first code block 151a.

At reference number 765, the baseband processing circuitry 123 performs a chase combining on the retransmitted code block 267a-n and the corresponding code block 151a-n. The chase combining may be implemented as at least a portion of the HARQ process by the HARQ module 132 (FIG. 1). If there are remaining retransmitted code blocks to be individually processed, as seen at reference number 768, then the baseband processing circuitry 123 branches to reference number 771.

At reference number 771, the baseband processing circuitry 123 removes data stored in the IR buffer 135 for increasing buffer capacity to store currently processed data. At reference number 774, the baseband processing circuitry 123 separates the next retransmitted code block 267b-n to facilitate the individual processing of each remaining retransmitted code block 267b-n.

If there are no remaining retransmitted code blocks 267b-n to be processed and/or decoded, the baseband processing circuitry 123 branches to reference number 777. At reference number 777, the baseband processing circuitry 123 performs error detection. For example, the baseband processing circuitry 123 aggregates each of the combined retransmitted code blocks 267a-n and performs a CRC. It may be the case that the likelihood of passing CRC is greater for the combination of the retransmitted bit stream 267 and the original input bit stream 254 rather than just the original input bit stream 254.

At reference number 781, if the CRC is passed, then at reference number 784, the baseband processing circuitry 123 removes the decoded block data from memory. Thus, the baseband processing circuitry 123 prepares for processing the next input bit stream. However, if the CRC is failed, then a new retransmitted bit stream may be received in the baseband processing circuitry 123.

The baseband processing circuitry 123 implemented in the receiver system 100 (FIG. 1), and other various systems described herein may be embodied in software or code executed by general purpose hardware. As an alternative, the same may also be embodied in dedicated hardware or a combination of software/general purpose hardware and dedicated hardware. If embodied in dedicated hardware, each can be implemented as a circuit or state machine that employs any one of or a combination of a number of technologies. These technologies may include, but are not limited to, discrete logic circuits having logic gates for implementing various logic functions upon an application of one or more data signals, application specific integrated circuits having appropriate logic gates, or other components, etc. Such technologies are generally well known by those skilled in the art and, consequently, are not described in detail herein.

The flowcharts of FIGS. 6A and 6B show the functionality and operation of an implementation of portions of the baseband processing circuitry 123 implemented in the receiver system 100. If embodied in software, each block, indicated by a reference number, may represent a module, segment, or portion of code that comprises program instructions to implement the specified logical function(s). The program instructions may be embodied in the form of source code that comprises human-readable statements written in a programming language or machine code that comprises numerical instructions recognizable by a suitable execution system such as a processor in a computer system or other system. The machine code may be converted from the source code, etc. If embodied in hardware, each block, indicated by a reference number, may represent a circuit or a number of interconnected circuits to implement the specified logical function(s).

Although the flowcharts of FIGS. 6A and 6B show a specific order of execution, it is understood that the order of execution may differ from that which is depicted. For example, the order of execution of two or more blocks may be scrambled relative to the order shown. Also, two or more blocks shown in succession in FIGS. 6A and 6B may be executed concurrently or with partial concurrence. Further, in some embodiments, one or more of the blocks shown in FIGS. 6A and 6B may be skipped or omitted. In addition, any number of counters, state variables, warning semaphores, or messages might be added to the logical flow described herein, for purposes of enhanced utility, accounting, performance measurement, or providing troubleshooting aids, etc. It is understood that all such variations are within the scope of the present disclosure.

Also, any logic or application described herein, including the baseband processing circuitry 123 that comprises software or code can be embodied in any non-transitory computer-readable medium for use by or in connection with an instruction execution system such as, for example, a processor in a computer system or other system. In this sense, the logic may comprise, for example, statements including instructions and declarations that can be fetched from the computer-readable medium and executed by the instruction execution system. In the context of the present disclosure, a "computer-readable medium" can be any medium that can contain, store, or maintain the logic or application described herein for use by or in connection with the instruction execution system.

The computer-readabte medium can comprise any one of many physical media such as, for example, magnetic, optical, or semiconductor media. More specific examples of a suitable computer-readable medium would include, but are not limited to, magnetic tapes, magnetic floppy diskettes, magnetic hard drives, memory cards, solid-state drives, USB flash drives, or optical discs. Also, the computer-readable medium may be a random access memory (RAM) including, for example, static random access memory (SRAM) and dynamic random access memory (DRAM), or magnetic random access memory (MRAM). In addition, the computer-readable medium may be a read-only memory (ROM), a programmable read-only memory (PROM), an erasable programmable read-only memory (EPROM), an electrically erasable programmable read-only memory (EEPROM), or other type of memory device.

It should be emphasized that the above-described embodiments of the present disclosure are merely possible examples of implementations set forth for a clear understanding of the principles of the disclosure. Many variations and modifications may be made to the above-described embodiment(s) without departing substantially from the spirit and principles of the disclosure. All such modifications and variations are intended to be included herein within the scope of this disclosure and protected by the following claims.

## Claims

1. A method comprising:
dividing an input bit stream into a set of code blocks and separating a first code block from the set of code blocks;
performing a hybrid automatic repeat request (HARQ) process on the first code block to generate a processed first code block;
storing the processed first code block in an incremental redundancy (IR) buffer;
performing a turbo decoding process on the processed first code block to generate decoded first code block data and storing the decoded first code block data in an external memory; and
removing the processed first code block from the IR buffer for decoding a remaining portion of the set of code blocks.

2. The method of claim 1, further comprising
separating a second code block from the set of code blocks;
performing the HARQ process on the second code block to generate a processed second code block;
wherein removing the processed first code block from the IR buffer for decoding a remaining portion of the set of code blocks comprises storing the processed second code block in the IR buffer.

3. The method of claim 1 or 2, further comprising:
individually performing the HARQ process on each code block of the set of code blocks to generate corresponding processed code blocks;
individually performing the turbo decoding process on each of the processed code blocks to generate corresponding decoded code block data;
aggregating each of the decoded code block data to generate a decoded bit stream; and
performing an error detection process on the decoded bit stream to generate an error detection value.

4. The method of claim 3, further comprising removing the decoded code block data associated with each code block from the external memory and the IR buffer in response to the error detection value matching a predetermined expected value.

5. The method of claim 3 or 4, further comprising:
receiving a transmitted bit stream in response to the error detection value not matching a predetermined expected value; and
dividing the retransmitted bit stream into retransmitted code blocks, wherein the retransmitted code blocks comprise a first retransmitted code block, the first retransmitted code block corresponding to the first code block.

6. The method of claim 5, further comprising storing the first retransmitted code block in the IR buffer and loading the first code block into the IR buffer from the external memory.

7. The method of claim 6, further comprising performing a chase combining process on the first retransmitted code block and the first code block by performing a read operation from the IR buffer.

8. The method of any preceding claim, wherein performing the turbo decoding process comprises executing a set of decoders to decode the first code block in parallel.

9. A system comprising:
baseband processing circuitry configured to divide an input bit stream into a set of code blocks;
an incremental redundancy (IR) buffer configured to individually store each code block;
a turbo decoder module configured to individually decode each code block to generate corresponding decoded code block data, each code block being sequentially read from the IR buffer, the turbo decoder module comprising a set of parallel turbo decoders configured for parallel processing; and
memory configured to store the decoded code block data associated with at least a portion of the set of code blocks.

10. The system of claim 9, wherein the set of code blocks comprises a first code block, wherein the turbo decoder module is configured to segment the first code block into code block segments, wherein the turbo decoder module is configured to allocate each code block segment to a corresponding parallel turbo decoder, wherein each code block segment is divided into a predetermined number of sequential evaluation windows for processing each code block segment in parallel.

11. The system of claim 10, wherein each parallel turbo decoder is configured to perform a forward probabilities alpha operation and a backward probabilities beta operation for each evaluation window to generate the decoded code block data.

12. The system of claim 11, wherein the forward probabilities alpha operation and the backward probabilities beta operation are performed simultaneously for each evaluation window.

13. The system of claim 12, wherein each parallel turbo decoder is configured to calculate respective log likelihood ratio data for each evaluation window by employing the forward probabilities alpha operation and the backward probabilities beta operation, wherein the calculation of the respective log likelihood ratio data for each evaluation window is initialized at a predetermined intermediate point in the evaluation window.

14. The system of any of claims 9 to 13, wherein the set of parallel turbo decoders is arranged as a first subset of parallel turbo decoders and a second subset of parallel turbo decoders, wherein the first subset of parallel turbo decoders is configured to start decoding the corresponding set of code block segments according to a first start time, wherein the second subset of parallel turbo decoders is configured to start decoding the corresponding set of code block segments according to a second start time, wherein the second start time is staggered from the first start time.

15. A system comprising:
processing circuitry configured to:
divide an input bit stream of a transmission time interval into a set of code blocks, each code block having a fixed length;
sequentially store each code block in an incremental redundancy (IR) buffer; and
individually decode, by a turbo decoder module, each code block to generate corresponding decode data for the respective code block, the turbo decoder module comprising a set of parallel turbo decoders configured for parallel processing.
